# EUROPEAN PATENT APPLICATION

(11) **EP 4 174 971 A1**
(43) Date of publication of application: **03.05.2023**
(21) Application number: 21829585.5
(22) Date of filing: 28.05.2021
(51) Int. Cl.: H01L 51/44, H01L 51/46

(54) **SOLAR CELL**

(30) Priority: 24.06.2020 JP 2020109160
(71) Applicant: Panasonic Intellectual Property Management Co., Ltd., Osaka-shi, Osaka 540-6207 (JP)
(72) Inventor: SEKIMOTO, Takeyuki, Osaka-shi, Osaka 540-6207 (JP); YAMAMOTO, Teruaki, Osaka-shi, Osaka 540-6207 (JP)
(74) Representative: Grünecker Patent- und Rechtsanwälte PartG mbB
(86) International application number: PCT/JP2021/020535
(87) International publication number: WO 2021/261176

(57) **Abstract**

A solar cell 100 according to the present disclosure includes a first electrode 2, an intermediate layer 8, a photoelectric conversion layer 3, and a second electrode 4 in this order. The intermediate layer 8 contains at least one compound A selected from predefined compound group I and at least one compound B selected from predefined compound group II.

## Description

### Technical Field

The present disclosure relates to a solar cell.

### Background Art

In recent years, research and development for perovskite solar cells, which are made using perovskite crystals represented by the compositional formula ABXs (A represents monovalent cations, B represents divalent cations, and X represents halide anions) or their analogous structures (hereinafter referred to as "perovskite compounds") as photoelectric conversion materials, have been ongoing. Various attempts have been made to improve the photoelectric conversion efficiency, photodurability, and thermal durability of perovskite solar cells.

NPL 1 discloses that placing 4-(1',5'-Dihydro-1'-methyl-2'H-[5,6]fullereno-C₆₀-Ih-[1,9-c]pyrrol-2'-yl)benzoic acid (hereinafter also referred to as "SAM[1]"), which is one of self-assembled monolayers having fullerene (C₆₀) (hereinafter also referred to as "C60SAMs"), at the interface between the electron transport layer (hereinafter also referred to as "ETL") and the photoelectric conversion layer of a perovskite solar cell increases photoelectric conversion efficiency by improving electron extraction. The literature suggests that the C60SAM is self-assembled in an arrangement in which the oxygens in its carboxyl group face the ETL to work as anchors while its C₆₀ faces the photoelectric conversion layer.

NPL 2 discloses that placing the C60SAM described in NPL 1 at the interface between the ETL and the photoelectric conversion layer of a perovskite solar cell improves photodurability.

NPL 3 discloses, regarding isonicotinic acid, that the oxygens in its carboxyl group faces titanium oxide (i.e., TiO₂) to work as anchors, becoming adsorbed onto the titanium oxide and modifying the surface.

NPL 4 discloses that mixing a C60SAM having a long alkyl chain from C₆H₁₂ to C₁₈H₃₆ (hereinafter also referred to as "long-chain C60SAM") and a C₆₀-free self-assembled monolayer having a long alkyl chain from C₆H₁₂ to C₁₈H₃₆ (hereinafter also referred to as "long-chain SAM") together limits the bending of the long-chain C60SAM, helping improve its alignment.

NPL 5 discloses a group of C60SAMs having a size similar to that of the C60SAM described in NPL 1 and having an anchoring carboxyl, catechol, or phosphoryl group at the same time.

NPL 6 suggests that inhibiting the cathodic reaction at the interface between the ETL and the photoelectric conversion layer (Pb²⁺ + 2e⁻→ Pb⁰) is an effective way to inhibit light-induced degradation reactions in a perovskite solar cell.

### Citation List

### Non Patent Literature

NPL 1: Konrad Wojciechowski and ten others, ACS Nano, November 2014, Vol. 8, pp. 12701-12709.
NPL 2: Meiyue Liu and four others, Materials Chemistry Frontiers, January 2019, Issue 3, pp. 496-504.
NPL 3: J. Schnadt and five others, Physical Review B, June 2003, Vol. 67, p. 235420.
NPL 4: Artoem Khassanov and four others, Accounts of chemical research, June 2015, Vol. 48, pp. 1901-1908.
NPL 5: Steven K. Hau and five others, ACS Applied Materials & Interfaces, June 2010, Vol. 2, pp. 1892-1902.
NPL 6: Takeyuki Sekimoto and five others, ACS Applied Energy Materials, June 2019, Vol. 2, pp. 5039-5049.
NPL 7: Mojtaba Abdi-Jalebi and ten others, Science Advances, February 2019, Vol. 5, p. eaav2012.

### Summary of Invention

### Technical Problem

An object of the present disclosure is to provide a solar cell having a high photoelectric conversion efficiency.

### Solution to Problem

A solar cell according to the present disclosure includes:
a first electrode, an intermediate layer, a photoelectric conversion layer, and a second electrode in this order, wherein:
the intermediate layer contains at least one compound A selected from compound group I, which consists of formulae (1) to (4) below, and at least one compound B selected from compound group II, which consists of formulae (5) and (6) below.

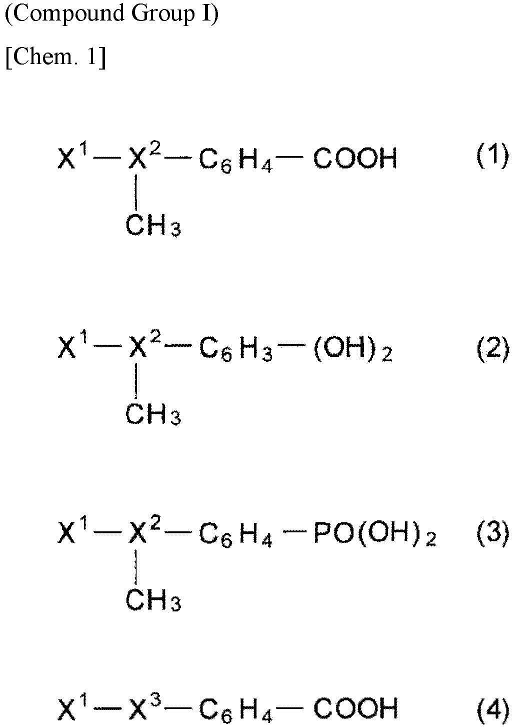

In formulae (1) to (4) above,
X¹ is fullerene or a fullerene derivative,
X² is a pyrroline ring, pyrrole ring, pyrrolidine ring, cyclohexane ring, or cyclohexene ring, and
X³ is a cyclohexadiene ring.

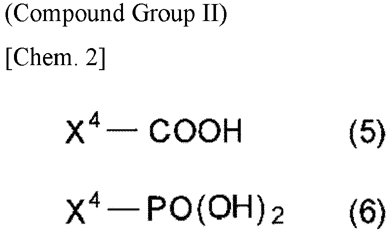

In formulae (5) and (6) above,
X⁴ is a heterocycle containing a heteroatom with one or more lone electron pairs and having a size smaller than or equal to 900 pm at the same time, optionally with at least a subset of hydrogen atoms in the heterocycle replaced with a halogen atom. Advantageous Effects of Invention

The present disclosure provides a solar cell having a high photoelectric conversion efficiency.

### Brief Description of Drawings

[Fig. 1] Fig. 1 is a schematic view illustrating an exemplary state of SAM[1], an example of a C60SAM, modifying the surface of an electron transport layer.
[Fig. 2] Fig. 2 is a schematic view illustrating an exemplary state of SAM[1], an example of a C60SAM, and isonicotinic acid, an example of a space-modifying SAM, modifying the surface of an electron transport layer.
[Fig. 3] Fig. 3 is a diagram illustrating examples of mass spectra obtained through a time-of-flight secondary-ion mass spectrometry (i.e., TOF-SIMS) analysis of the surface of an intermediate layer covering the surface of an electron transport layer when the intermediate layer was formed by SAM[1] or SAM[1] and isonicotinic acid.
[Fig. 4] Fig. 4 is a diagram illustrating examples of mass spectra obtained through a TOF-SIMS analysis of the surface of an intermediate layer covering the surface of an electron transport layer when the intermediate layer was formed by SAM[1] or SAM[1] and isonicotinic acid.
[Fig. 5] Fig. 5 is a schematic sectional view illustrating a first example of a solar cell according to an embodiment.
[Fig. 6] Fig. 6 is a schematic sectional view illustrating a second example of a solar cell according to an embodiment.
[Fig. 7] Fig. 7 is a schematic sectional view illustrating a third example of a solar cell according to an embodiment.
[Fig. 8] Fig. 8 is a schematic sectional view illustrating a fourth example of a solar cell according to an embodiment.

### Description of Embodiments

### <Underlying Knowledge Forming Basis of the Present Disclosure>

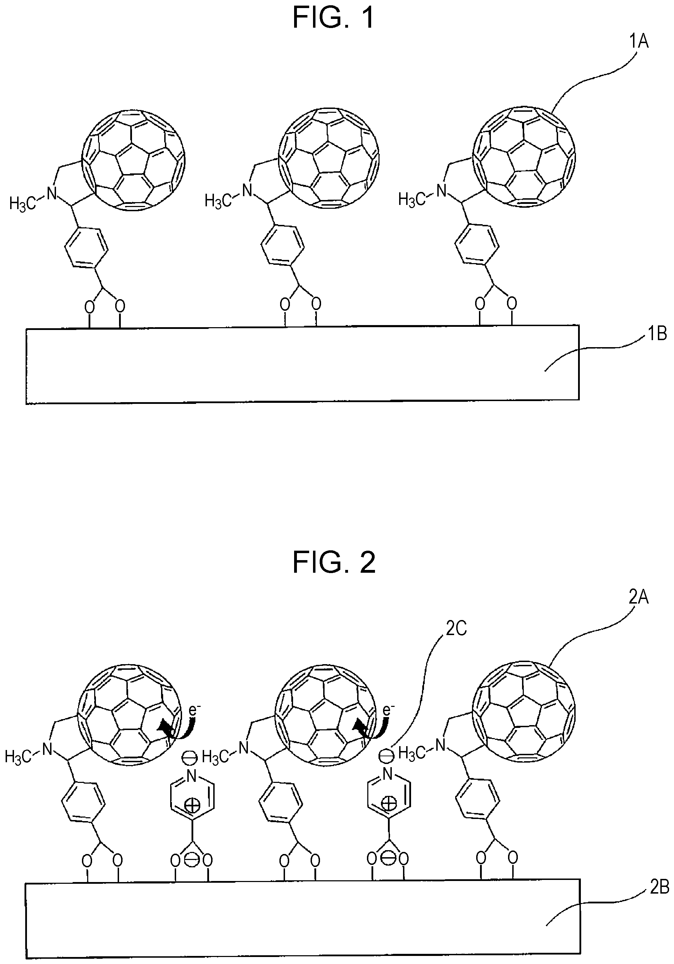

A C60SAM is formed by C₆₀ (size: 0.7 nm), extremely potent in collecting electrons, and a chain moiety including components like a carboxyl group (size: approximately 1 nm). Fig. 1 is a schematic view illustrating an exemplary state of SAM[1], an example of a C60SAM, modifying the surface of an electron transport layer. As illustrated in Fig. 1, the SAM[1] 1A is self-assembled with the oxygens in its anchoring carboxyl group facing the electron transport layer 1B and the C₆₀ facing the photoelectric conversion layer. The improvement in photoelectric conversion efficiency provided by the introduction of a C60SAM in NPL 1 is attributable to defect passivation at the interface between the electron transport layer and the photoelectric conversion layer achieved by the modification of the surface of the electron transport layer with the C60SAM and an improvement in electron extraction yielded by the highly electrically conductive C₆₀. The improvement in photodurability achieved by the introduction of a C60SAM in NPL 2 can be interpreted as a result of reduced degradation from the cathodic reaction, pointed out in NPL 6, at the interface between the electron transport layer and the photoelectric conversion layer associated with the improved efficiency in the extraction of high-energy, photoexcited electrons owing to the introduction of the C60SAM.

As can be seen from this, the introduction of a C60SAM to the interface between the electron transport layer and the photoelectric conversion layer leads to an improvement in photodurability. There has been, however, a disadvantage: With a known C60SAM, the C₆₀ is large in size, and its steric hindrance causes spaces, or unmodified areas, to be created on the surface of the electron transport layer when the surface of the electron transport layer is passivated. As a result, the electron transport layer and the photoelectric conversion layer come into direct contact, unfortunately leaving regions with many interfacial defects and, therefore, of poor electron extraction, preventing the C60SAM from producing its full effect. This disadvantage remains even if the group of C60SAMs described in NPL 5 is used.

The long-chain C60SAM described in NPL 4 has poor electrical conductivity in its long alkyl chain moiety. It, therefore, has the disadvantage that it produces resistive losses. Even though the alignment is improved by introducing a long-chain SAM, the resistive losses are not improved because this long-chain SAM itself has a long alkyl chain.

If isonicotinic acid, which is a small-sized (<1 nm) SAM, is introduced alone to the interface between the electron transport layer and the photoelectric conversion layer as described in NPL 3, surface defects in the electron transport layer are successfully passivated without steric hindrance. This, however, affects photoelectric conversion efficiency because a negatively charged nitrogen atom in the pyridine ring of the isonicotinic acid repulses electrons, affecting the electron-collecting potential. As electron extraction efficiency decreases, furthermore, high-energy, photoexcited electrons are stored at the interface between the electron transport layer and the photoelectric conversion layer during light illumination, accelerating the cathodic reaction at the interface. It is, therefore, expected that photodurability also lowers.

After doing extensive research considering these discussions, the inventor found the following. Fig. 2 is a schematic view illustrating an exemplary state of SAM[1], an example of a C60SAM, and isonicotinic acid, an example of a space-modifying SAM, modifying the surface of an electron transport layer. It was found that placing SAM[1] 2A and isonicotinic acid 2C as an SAM modifying spaces between its molecules (i.e., space-modifying SAM) as illustrated in Fig. 2 helps reduce interfacial defects caused by contact between the electron transport layer 2B and the photoelectric conversion layer (not illustrated). It was also found that increasing electron collection into the C₆₀ of the SAM[1] 2A by repulsing electrons with the isonicotinic acid 2C helps further improve photoelectric conversion efficiency while controlling the phenomenon of light-induced degradation. As used herein, "space-modifying SAM" includes heterocyclic compounds that can enter spaces between adjacent C60SAM molecules, and a heterocyclic compound in this context represents a self-assembled monolayer that has a heterocycle containing an element with one or more lone electron pairs.

### <Overview of an Aspect according to the Present Disclosure>

A solar cell according to a first aspect of the present disclosure includes:
a first electrode, an intermediate layer, a photoelectric conversion layer, and a second electrode in this order, wherein:
the intermediate layer contains at least one compound A selected from compound group I, which consists of formulae (1) to (4) below, and at least one compound B selected from compound group II, which consists of formulae (5) and (6) below.

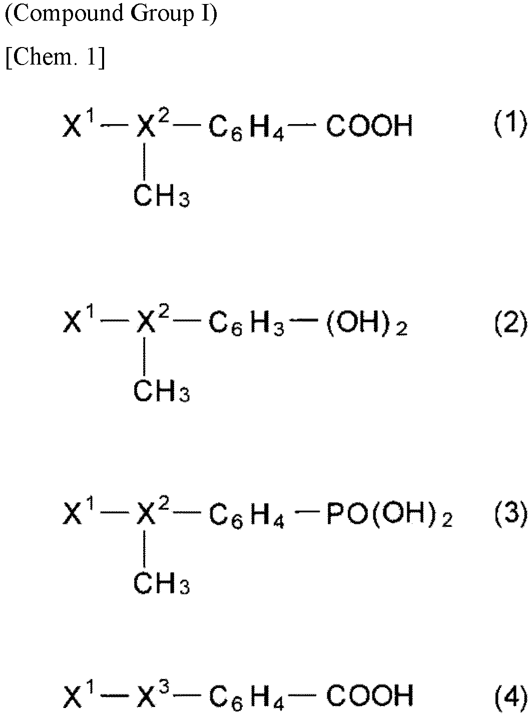

In formulae (1) to (4) above,
X¹ is fullerene or a fullerene derivative,
X² is a pyrroline ring, pyrrole ring, pyrrolidine ring, cyclohexane ring, or cyclohexene ring, and
X³ is a cyclohexadiene ring.

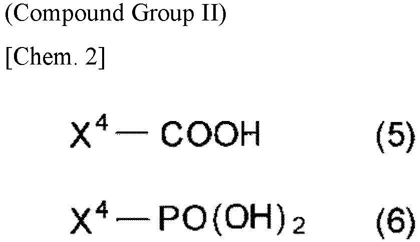

In formulae (5) and (6) above,
X⁴ is a heterocycle containing a heteroatom with one or more lone electron pairs and having a size smaller than or equal to 900 pm at the same time, optionally with a subset of the hydrogen atoms in the heterocycle replaced with a halogen atom.

With the solar cell according to the first aspect, interfacial recombination caused by direct contact between the first electrode and the photoelectric conversion layer can be reduced. The element with lone electron pair(s) in the heterocycle of the compound B, furthermore, is negatively charged and effectively repulses electrons coming from the photoelectric conversion layer, thereby increasing electron collection into the X¹ of the compound A. With the solar cell according to the first aspect, therefore, photoelectric conversion efficiency can be improved with the phenomenon of light-induced degradation controlled.

In a second aspect of the present disclosure, the solar cell according to the first aspect, for example, may further include an electron transport layer, and the electron transport layer may be between the first electrode and the intermediate layer.

The solar cell according to the second aspect is able to efficiently move electrons to the first electrode by virtue of further including an electron transport layer. The solar cell according to the second aspect, therefore, allows for efficient extraction of electric current. Because there is an intermediate layer between the electron transport layer and the photoelectric conversion layer, furthermore, interfacial recombination caused by direct contact between the electron transport layer and the photoelectric conversion layer is also reduced. The element with lone electron pair(s) in the heterocycle of the compound B is negatively charged and effectively repulses electrons coming from the photoelectric conversion layer, thereby increasing electron collection into X¹ of the compound A. With the solar cell according to the second aspect, therefore, the photoelectric conversion efficiency can be further improved with the phenomenon of light-induced degradation controlled.

In a third aspect of the present disclosure, the compound A in the solar cell according to the first or second aspect, for example, may be at least one selected from the compounds represented by formulae (7) to (11) below, and the compound B may be at least one selected from the group consisting of isonicotinic acid, nicotinic acid, and picolinic acid.

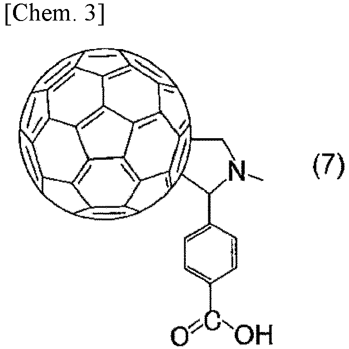

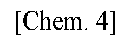

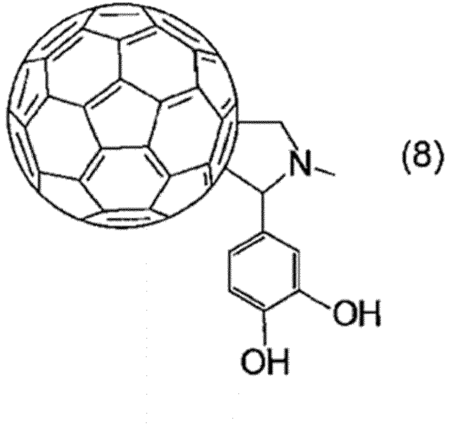

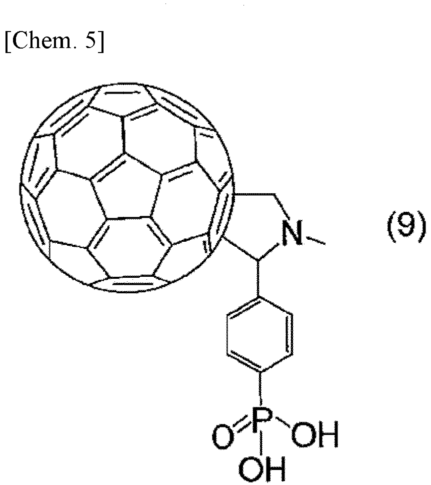

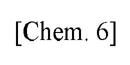

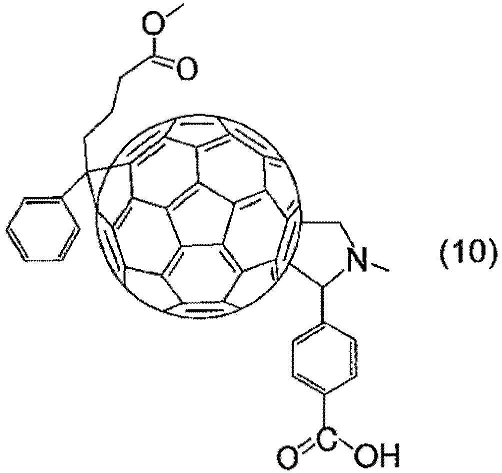

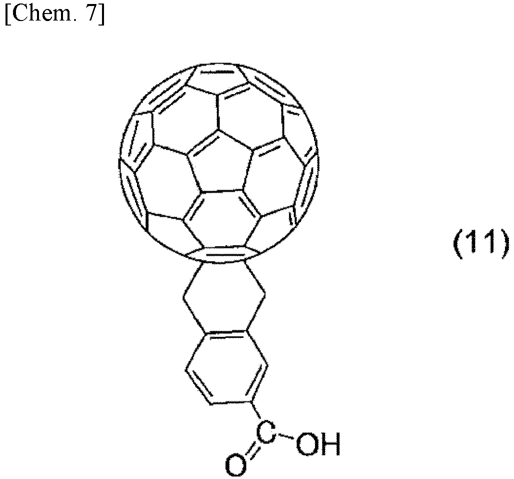

With the third aspect, the photoelectric conversion efficiency can be further improved with the phenomenon of light-induced degradation controlled.

In a fourth aspect of the present disclosure, the compound A in the solar cell according to the third aspect, for example, may be the compound represented by formula (7) above.

With the fourth aspect, the photoelectric conversion efficiency can be further improved with the phenomenon of light-induced degradation controlled.

In a fifth aspect of the present disclosure, the photoelectric conversion layer of the solar cell according to any one of the first to fourth aspects, for example, may contain a perovskite compound.

Perovskite compounds have a high optical absorption coefficient for the wavelength band of the spectrum of solar radiation and have a high carrier mobility at the same time. With the solar cell according to the fifth aspect, therefore, a high photoelectric conversion efficiency is expected.

In a sixth aspect of the present disclosure, the electron transport layer of the solar cell according to the second aspect, for example, may contain titanium oxide or tin oxide.

The lowest energy levels in the conduction bands of titanium oxide and tin oxide and the LUMO levels of compounds A are close to the lowest energy levels of the conduction bands of perovskite compounds. The compound A, therefore, does not interfere with electron transport from the photoelectric conversion layer to the electron transport layer. The lowest energy levels in the conduction bands of titanium oxide and tin oxide are, for example, from 4.0 eV to 4.2 eV. The LUMO level of a C60SAM, an example of a compound A, is, for example, 3.9 eV. The lowest energy levels of the conduction bands of perovskite compounds are, for example, from 3.9 eV to 4.1 eV. The band gap of TiO₂ and that of SnO₂ are 3.0 eV to 3.2 eV and 3.8 eV to 4.2 eV, respectively, broader than 1.3 eV to 1.7 eV, which is the band gap of a typical perovskite compound. By virtue of the presence of titanium oxide or tin oxide in the electron transport layer, therefore, optical absorption losses caused by the electron transport layer are reduced. The intermediate layer, on the other hand, only has a thickness of roughly one single molecule, which means optical absorption losses caused by the intermediate layer are extremely small. With the solar cell according to the sixth aspect, therefore, a high photoelectric conversion efficiency is expected.

### <Embodiments>

A solar cell according to the present disclosure includes:
a first electrode, an intermediate layer, a photoelectric conversion layer, and a second electrode in this order, and
the intermediate layer contains at least one compound A selected from compound group I, which consists of formulae (1) to (4) above, and at least one compound B selected from compound group II, which consists of formulae (5) and (6) above.

In formulae (1) to (4) above, X¹ is fullerene or a fullerene derivative, X² is a pyrroline ring, pyrrole ring, pyrrolidine ring, cyclohexane ring, or cyclohexene ring, and X³ is a cyclohexadiene ring.

In formulae (5) and (6) above, X⁴ is a heterocycle containing a heteroatom with one or more lone electron pairs and having a size smaller than or equal to 900 pm at the same time, optionally with at least a subset of the hydrogen atoms in the heterocycle replaced with a halogen atom.

The heteroatom with one or more lone electron pairs represents nitrogen, oxygen, or sulfur.

The size of the heterocycle means the longest distance between two of the atoms constituting the heterocycle plus the atomic radii of the two atoms.

The size of the heterocycle can be measured by, for example, x-ray diffraction, neutron diffraction, electron beam diffraction, or the crystalline sponge method.

In formulae (5) and (6) above, X⁴ may be a heterocycle having a size smaller than or equal to 795 pm.

In formulae (5) and (6) above, the heterocycle denoted by X⁴ may be a pyridine ring, pyran ring, furan ring, oxetane ring, oxazole ring, isoxazole ring, pyridazine ring, pyrimidine ring, pyrazine ring, triazine ring, tetrazine ring, triazole ring, thiophene ring, thiazole ring, dioxane ring, pyrazole ring, imidazole ring, phosphinine ring, oxirane ring, thiirane ring, thietane ring, imidazoline ring, dioxolane ring, tetrahydrofuran ring, tetrahydrothiophene ring, morpholine ring, dithiane ring, quinuclidine ring, or azaadamantane ring. With these arrangements, the photoelectric conversion efficiency can be further improved with the phenomenon of light-induced degradation controlled.

The solar cell according to the present disclosure may further include an electron transport layer, and the electron transport layer may be between the first electrode and the intermediate layer.

The TOF-SIMS intensity ratio Ri is defined as the ratio, in a mass spectrum obtained through time-of-flight secondary-ion mass spectrometry (TOF-SIMS), of the total intensity of secondary ions in the peaks for isonicotinic acid, nicotinic acid, or picolinic acid (m/z=78, 79, 94, 122, and 123) to the total intensity of secondary ions in the peaks for SAM[1] (m/z=720 and 897.1). The TOF-SIMS measurement is acquired using, for example, the following equipment and measuring parameters.
- TOF-SIMS system: TOF.SIMS 5 (manufactured by ION-TOF GmbH)
- Primary ion: Bi₃⁺
- Acceleration voltage for the primary ion: 30 kV
- Polarity of secondary ions being detected: Negative
- Scan area: 200 µm×200 µm

The TOF-SIMS measurement is performed at an uncovered area of the intermediate layer, on which no photoelectric conversion or upper layer has been formed. Alternatively, the measurement is performed at an area of the intermediate layer uncovered by removing the photoelectric conversion layer by dissolving it with a DMSO/DMF mixed solution in which the ratio by volume DMSO:DMF=4: 1.

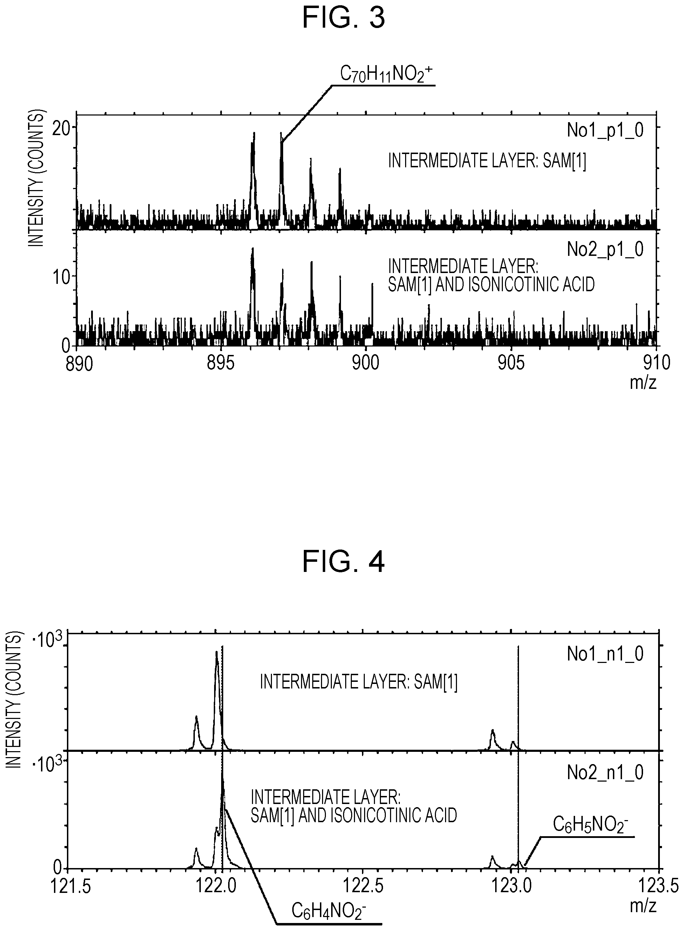

Fig. 3 is a diagram illustrating examples of mass spectra obtained through a time-of-flight secondary-ion mass spectrometry (i.e., TOF-SIMS) analysis of the surface of an intermediate layer covering the surface of an electron transport layer when the intermediate layer was formed by SAM[1] or SAM[1] and isonicotinic acid. Fig. 4 is a diagram illustrating examples of mass spectra obtained through a TOF-SIMS analysis of the surface of an intermediate layer covering the surface of an electron transport layer when the intermediate layer was formed by SAM[1] or SAM[1] and isonicotinic acid.

There is a positive correlation between the TOF-SIMS intensity ratio Ri and the initial concentration ratio of isonicotinic acid, nicotinic acid, and picolinic acid. The TOF-SIMS intensity ratio Ri, therefore, essentially represents the amount of the compound B, which is at least one selected from the group consisting of isonicotinic acid, nicotinic acid, and picolinic acid, relative to the compound A, which is SAM[1]. The initial concentration ratio of isonicotinic acid, nicotinic acid, and picolinic acid is calculated according to the numerical formula: a×c2/c1. "a" is the concentration of a saturated solution of the C60SAM, "c1" is the molarity of SAM[1], and "c2" is the molarity of isonicotinic acid, nicotinic acid, and picolinic acid.

The fullerene may be, for example, the most common C₆₀ fullerene or may be a macromolecular fullerene, which is formed by 70 or more carbon atoms, or an endohedral fullerene, which has an atom or molecule encapsulated in the hollow framework of a fullerene. A fullerene derivative is a compound produced by introducing a new chemical species into a fullerene through a chemical modification, such as an addition reaction. Examples of fullerene derivatives include compounds like Phenyl-C₆₁-Butyric-Acid-Methyl-Ester (PCBM), Indene-C₆₀-Monoadduct, Indene-C₆₀-Bisadduct, N-Methylfulleropyrrolidine, N-2-Diphenyl[60]fulleropyrrolidine, and N-Phenyl-2-hexyl [60] full eropyrroli dine.

The compound A may be at least one selected from the compounds represented by formulae (7) to (11) above, and the compound B may be at least one selected from the group consisting of isonicotinic acid, nicotinic acid, and picolinic acid. Isonicotinic acid, nicotinic acid, and picolinic acid are represented by formulae (12) to (14) below.

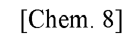

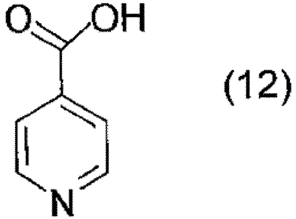

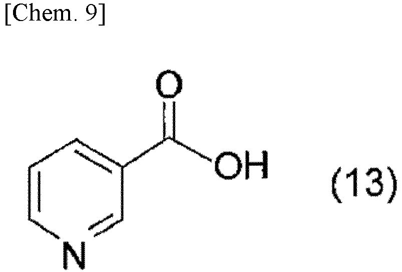

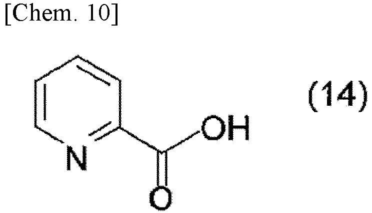

The compound A may be the compound represented by formula (7) above.

A solar cell according to an embodiment of the present disclosure will now be described, taking the example of a case in which the compound A is at least one selected from the compounds of formulae (1) to (4) in which X¹ is the fullerene C₆₀. In the following, four exemplary structures of solar cells (first to fourth examples) and methods for producing them will be described in detail with reference to drawings. Hereinafter, the compound A is referred to as the C60SAM, and the compound B is referred to as the space-modifying SAM.

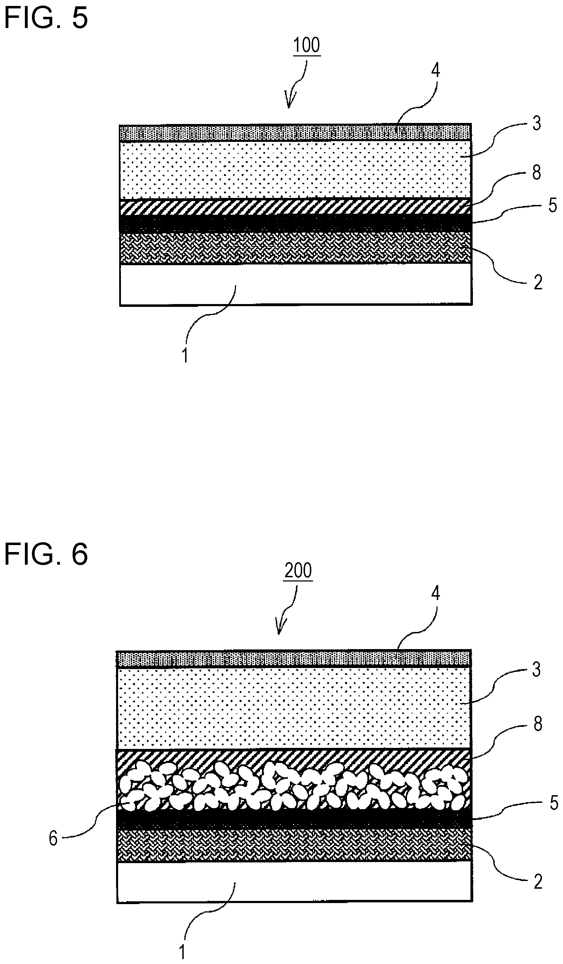

Fig. 5 is a schematic sectional view illustrating a first example of a solar cell according to an embodiment.

The solar cell 100 illustrated in Fig. 5 includes a substrate 1, a first electrode 2, an electron transport layer 5, an intermediate layer 8, a photoelectric conversion layer 3, and a second electrode 4 in this order. The intermediate layer 8 contains the C60SAM and the space-modifying SAM. The solar cell 100 does not need to have the substrate 1. The solar cell 100 does not need to have the electron transport layer 5.

When the solar cell 100 is irradiated with light, the photoelectric conversion layer 3 absorbs the light, generating excited electrons and holes. The excited electrons travel through the electron transport layer 5 to the first electrode 2 via the intermediate layer 8. The holes generated in the photoelectric conversion layer 3, on the other hand, travel to the second electrode 4. Through this, the solar cell 100 allows for the extraction of electric current from its negative first electrode 2 and positive second electrode 4. If the surface of the electron transport layer 5 has a portion not modified with the C60SAM and space-modifying SAM contained in the intermediate layer 8, the excited electrons can travel directly through the electron transport layer 5 to the first electrode 2.

The solar cell 100 can be fabricated, for example, by the following method.

First, the first electrode 2 is formed on the surface of the substrate 1, for example by chemical vapor deposition or sputtering. Then the electron transport layer 5 is formed, for example by chemical vapor deposition, sputtering, or solution coating. Then the intermediate layer 8 is formed, for example by the method described in the Embodiments section. Then the photoelectric conversion layer 3 is formed on the intermediate layer 8. For example, a perovskite compound may be sliced to a predetermined thickness, and the resulting slice may be placed on the first electrode 2 as the photoelectric conversion layer 3. Then the second electrode 4 is formed on the photoelectric conversion layer 3. Through the foregoing, the solar cell 100 can be obtained.

The solar cell according to the present disclosure may include a porous layer 6. Fig. 6 is a schematic sectional view illustrating a second example of a solar cell according to an embodiment.

The solar cell 200 illustrated in Fig. 6 includes a substrate 1, a first electrode 2, an electron transport layer 5, a porous layer 6, an intermediate layer 8, a photoelectric conversion layer 3, and a second electrode 4 in this order. The porous layer 6 includes a porous material. The porous material includes pores. The solar cell 200 does not need to have the substrate 1. The solar cell 200 does not need to have the electron transport layer 5.

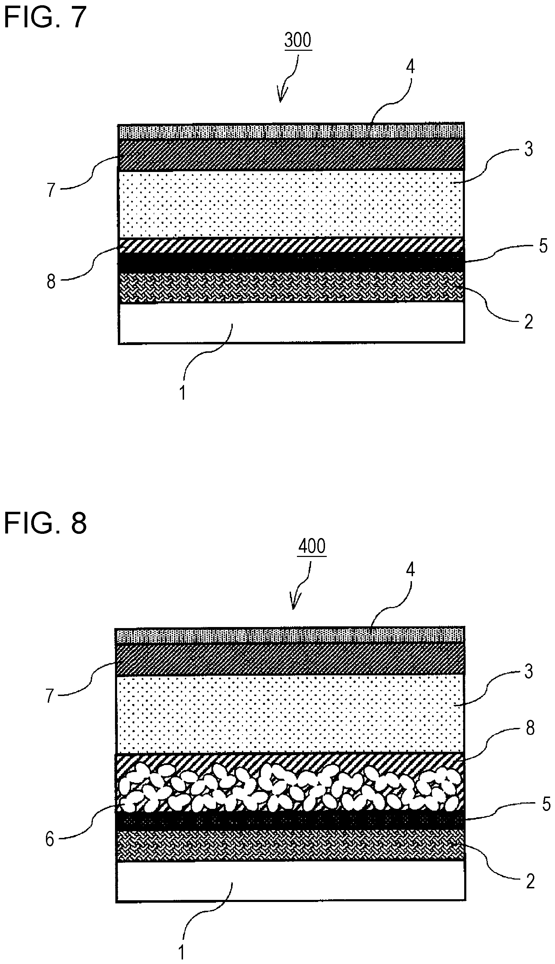

The solar cell according to the present disclosure may include a hole transport layer 7. Fig. 7 is a schematic sectional view illustrating a third example of a solar cell according to an embodiment.

The solar cell 300 illustrated in Fig. 7 includes a substrate 1, a first electrode 2, an electron transport layer 5, an intermediate layer 8, a photoelectric conversion layer 3, a hole transport layer 7, and a second electrode 4 in this order. The solar cell 300 does not need to have the substrate 1. The solar cell 300 does not need to have the electron transport layer 5.

When the solar cell 300 is irradiated with light, the photoelectric conversion layer 3 absorbs the light, generating excited electrons and holes. The excited electrons travel through the electron transport layer 5 via the intermediate layer 8. The holes generated in the photoelectric conversion layer 3, on the other hand, travel to the hole transport layer 7. The electron transport layer 5 is coupled to the first electrode 2, and the hole transport layer 7 is coupled to the second electrode 4. Through this, the solar cell 300 allows for the extraction of electric current from its negative first electrode 2 and positive second electrode 4.

Fig. 8 is a schematic sectional view illustrating a fourth example of a solar cell according to an embodiment.

The solar cell 400 illustrated in Fig. 8 includes a substrate 1, a first electrode 2, an electron transport layer 5, a porous layer 6, an intermediate layer 8, a photoelectric conversion layer 3, a hole transport layer 7, and a second electrode 4 in this order. The solar cell 400 does not need to have the substrate 1. The solar cell 400 does not need to have the electron transport layer 5.

Each component of the solar cell will now be described specifically.

### (Substrate 1)

The substrate 1 is an optional component. The substrate 1 serves to support each layer of the solar cell. The substrate 1 can be formed from a transparent material. The substrate 1 can be, for example, a glass or plastic substrate. A plastic substrate may be, for example, a plastic film. If the second electrode 4 is translucent, the material for the substrate 1 may be a material that is not translucent. For example, the material for the substrate 1 may be a metal, ceramic material, or low-translucency resin material. If the first electrode 2 is sufficiently strong, the substrate 1 may be omitted because each layer can be supported with the first electrode 2.

### (First Electrode 2)

The first electrode 2 is electrically conductive. If the solar cell includes no electron transport layer 5, the first electrode 2 is made of a material that does not form an ohmic contact with the photoelectric conversion layer 3. The first electrode 2, furthermore, has the ability to block holes coming from the photoelectric conversion layer 3. The ability to block holes coming from the photoelectric conversion layer 3 refers to a nature of being permeable only to electrons generated in the photoelectric conversion layer 3; a nature of being impermeable to holes. A material having such an ability is a material whose Fermi energy is higher than the highest energy in the valence band of the photoelectric conversion layer 3. This material may be a material whose Fermi energy is higher than the Fermi energy of the photoelectric conversion layer 3. A specific example of a material is aluminum. If the solar cell includes an electron transport layer 5 between its first electrode 2 and photoelectric conversion layer 3, the first electrode 2 does not need have the ability to block holes that travel from the photoelectric conversion layer 3. The first electrode 2 may be made of a material that can form an ohmic contact with the photoelectric conversion layer 3.

The first electrode 2 is translucent. For example, it transmits light in the visible to near-infrared range. The first electrode 2 can be formed using, for example, a transparent and electrically conductive metal oxide and/or metal nitride. Examples of such materials include titanium oxide doped with at least one selected from the group consisting of lithium, magnesium, niobium, and fluorine, gallium oxide doped with at least one selected from the group consisting of tin and silicon, gallium nitride doped with at least one selected from the group consisting of silicon and oxygen, tin oxide doped with at least one selected from the group consisting of antimony and fluorine, zinc oxide doped with at least one selected from the group consisting of boron, aluminum, gallium, and indium, indium-tin composite oxide, and composites thereof.

Alternatively, the first electrode 2 can be formed using a non-transparent material in a pattern that allows light to pass through it. Examples of patterns that allow light to pass through them include stripes, waves, a grid, and a pattern like perforated metal, perforated with many regularly or irregularly arranged small through holes. If the first electrode 2 has such a pattern, light can pass through the portions without the electrode material. Examples of electrode materials that are not transparent include platinum, gold, silver, copper, aluminum, rhodium, indium, titanium, iron, nickel, tin, zinc, and alloys containing any of them. An electrically conductive carbon material may also be used.

The optical transmittance of the first electrode 2 may be, for example, higher than or equal to 50% or may be higher than or equal to 80%. The wavelengths of light to be transmitted depend on the wavelengths the photoelectric conversion layer 3 absorbs. The thickness of the first electrode 2 is, for example, in the range of 1 nm to 1000 nm.

### (Electron Transport Layer 5)

The electron transport layer 5 includes a semiconductor. The electron transport layer 5 may be a semiconductor having a band gap greater than or equal to 3.0 eV. By forming the electron transport layer 5 with a semiconductor having a band gap greater than or equal to 3.0 eV, visible and infrared light can be transmitted to the photoelectric conversion layer 3. An example of a semiconductor is an inorganic n-type semiconductor.

An inorganic n-type semiconductor can be, for example, an oxide of a metal element, a nitride of a metal element, or a perovskite oxide. An oxide of a metal element can be, for example, an oxide of Cd, Zn, In, Pb, Mo, W, Sb, Bi, Cu, Hg, Ti, Ag, Mn, Fe, V, Sn, Zr, Sr, Ga, Si, or Cr. More specific examples include TiO₂ and SnO₂. An example of a nitride of a metal element is GaN. Examples of perovskite oxides include SrTiO₃ and CaTiO₃.

The electron transport layer 5 may be formed by a substance having a band gap greater than 6.0 eV. Examples of substances having a band gap greater than 6.0 eV include halides of alkali metals or alkaline earth metals, such as lithium fluoride and calcium fluoride, alkali metal oxides, such as magnesium oxide, and silicon dioxide. In that case, the electron transport layer 5 is formed to a thickness less than or equal to 10 nm, for example, to ensure the electron transport layer 5 will transport electrons.

The electron transport layer 5 may include multiple layers that are made of different materials.

### (Intermediate Layer 8)

The intermediate layer 8 contains the C60SAM and the space-modifying SAM.

The C60SAM has a macromolecular modifying group C₆₀. The C₆₀ is bound to the anchoring COOH, (OH)₂, or PO(OH)₂ not by a highly electrically resistant long alkyl chain but by a more electrically conductive benzene ring and X² or X³. By virtue of this, the resistive losses that occur when the electrons collected into C₆₀ are transported to the electron transport layer are reduced. The C60SAM passivates the electron transport layer 5. If the solar cell includes no electron transport layer 5, the C60SAM passivates the first electrode 2.

The compound C₆₀ Pyrrolidine tris-acid, represented by formula (15) below, and (1,2-Methanofullerene C₆₀)-61-carboxylic acid, represented by formula (16) below, are inappropriate for use as C60SAMs. The reason for this is that unpassivated areas would be left at the interface between the electron transport layer 5 or first electrode 2 and the photoelectric conversion layer 3, because the size of the framework excluding the C₆₀ is too small to secure a space for the below described space-modifying SAM to enter, or because an appropriate space-modifying SAM is not available.

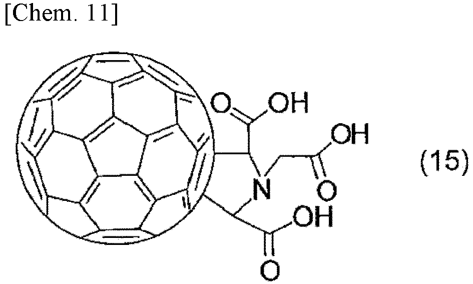

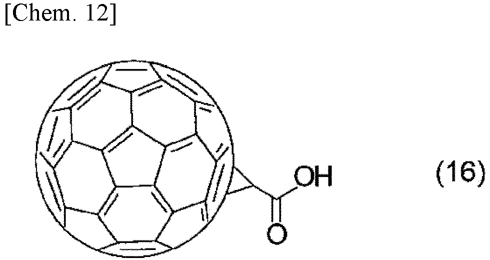

The COOH or PO(OH)₂ in the space-modifying SAM works as an anchor and passivates the electron transport layer 5 with their oxygen atoms. In some cases the COOH remains COOH when passivating the electron transport layer 5, and in others it turns into COO when passivating the electron transport layer 5. If the solar cell includes no electron transport layer 5, the COOH or PO(OH)₂ passivates the first electrode 2.

The size of the space-modifying SAM is smaller than the size of the framework of the C60SAM excluding the X¹. By virtue of this, the space-modifying SAM can enter spaces between adjacent C60SAM molecules. If the size of the space-modifying SAM is larger than the size of the framework of the C60SAM excluding the X¹, the unpassivated areas due to steric hindrance can increase.

The intermediate layer 8 passivates, with the space-modifying SAM, defects in the interface between the electron transport layer 5 or first electrode 2 and the photoelectric conversion layer 3 that the C60SAM alone has failed to passivate because of steric hindrance. By virtue of this, interfacial recombination caused by direct contact between the electron transport layer 5 or first electrode 2 and the photoelectric conversion layer 3 is reduced. The element having lone electron pair(s) included in the X⁴ of the space-modifying SAM, furthermore, is negatively charged. This allows the element to effectively repel electrons coming from the photoelectric conversion layer 3, and, as a result, electron collection into the X¹ of the C60SAM increases. The intermediate layer 8, therefore, further improves photoelectric conversion efficiency while limiting the phenomenon of light-induced degradation of the solar cell 100.

The intermediate layer 8 only needs to contain the C60SAM and the space-modifying SAM; it can contain impurities. The intermediate layer 8 may further contain extra compounds different from the C60SAM and the space-modifying SAM.

At least a subset of the hydrogen atoms in the X⁴ may be replaced with a halogen atom. For example, the hydrogen atom(s) may be replaced with a bromine atom. The hydrogen atom in the X⁴ do not have to be replaced with a halogen atom.

If the C60SAM is SAM[1] and if the space-modifying SAM is at least one selected from the group consisting of isonicotinic acid, nicotinic acid, and picolinic acid, the TOF-SIMS intensity ratio Ri of the intermediate layer 8 may be higher than or equal to 2.11 and lower than or equal to 24.5.

If the TOF-SIMS intensity ratio Ri is higher than or equal to 2.11, the defect passivation at the interface between the electron transport layer 5 and the photoelectric conversion layer 3 is sufficient. This further improves the photoelectric conversion efficiency. If the TOF-SIMS intensity ratio Ri is lower than or equal to 24.5, electron collection into the C₆₀ in the SAM[1] increases. This further improves the photoelectric conversion efficiency.

### (Method for Producing the Intermediate Layer)

An example of a method for producing the intermediate layer 8 will now be described. The following description takes the example of dipping, but this is not the only possible method for producing the intermediate layer 8.

First, a C60SAM solution is prepared. The C60SAM solution is obtained by adding the C60SAM to an organic solvent. The organic solvent is a mixed solution in which tetrahydrofuran and ethanol are mixed in a ratio by volume of 1: 1. A saturated solution of the C60SAM is obtained by passing the supersaturated C60SAM solution through a polytetrafluoroethylene filter (pore size of 0.2 µm). A low-concentration C60SAM solution is obtained by diluting the saturated solution of the C60SAM using a mixed solution in which tetrahydrofuran and ethanol are mixed in a ratio by volume of 1: 1.

Subsequently, a space-modifying SAM solution is prepared. The space-modifying SAM solution is obtained by adding the space-modifying SAM to an organic solvent. The organic solvent is a mixed solution in which tetrahydrofuran and ethanol are mixed in a ratio by volume of 1:1. The concentration of the space-modifying SAM may be higher than or equal to 0.01 g/L and lower than or equal to 1 g/L.

Then a substrate 1 with an electron transport layer 5 and a first electrode 2 formed thereon is immersed in the C60SAM solution for 30 minutes and then removed. The removed substrate 1 is thoroughly rinsed with an ethanol solution and then annealed on a hot plate at a temperature of 100°C for 30 minutes. Allowing the annealed substrate to cool naturally to room temperature gives a substrate 1 modified with the C60SAM.

Then the substrate 1 modified with the C60SAM is immersed in the space-modifying SAM solution for 30 minutes and then removed. The removed substrate is thoroughly rinsed with ethanol solution, and then annealed on a hot plate at 100°C for 30 minutes. Allowing the annealed substrate to cool naturally to room temperature gives a substrate 1 further modified with the space-modifying SAM. In such a way, the intermediate layer 8 is formed.

This method for producing the intermediate layer 8, in which a substrate 1 with an electron transport layer 5 and a first electrode 2 formed thereon is treated with the C60SAM and then further treated with the space-modifying SAM, is a two-stage process involving two treatments with an SAM. Alternatively, the intermediate layer 8 can be formed by a one-stage process in which the substrate is treated with SAMs once, using a mixed solution in which the concentrations of the C60SAM and the space-modifying SAM have been adjusted beforehand. That is, immersing a substrate 1 with an electron transport layer 5 and a first electrode 2 formed thereon in a mixed solution of the C60SAM and the space-modifying SAM for 30 minutes, thoroughly rinsing the removed substrate with an ethanol solution, annealing the rinsed substrate on a hot plate at 100°C for 30 minutes, and then allowing the annealed substrate to cool naturally to room temperature also produces the intermediate layer 8.

If the solar cell includes no electron transport layer 5, the intermediate layer 8 may be formed on the first electrode 2. In that case, the intermediate layer 8 works as the electron transport layer 5.

### (Photoelectric Conversion Layer 3)

The photoelectric conversion layer 3 contains a perovskite compound represented by the compositional formula ABXs. A represents monovalent cations. Examples of monovalent cations include monovalent cations like alkali metal cations and organic cations. More specific examples include the methylammonium cation (MA⁺ or CH₃NH₃⁺), the formamidinium cation (FA⁺ or HC(NH₂)₂⁺), the ethylammonium cation (CH₃CH₂NH₃⁺), the guanidinium cation (CH₆N₃⁺), the potassium cation (K⁺), the cesium cation (Cs⁺), and the rubidium cation (Rb⁺). B represents the divalent lead cation (Pb²⁺) and tin cation(Sn²⁺). X represents monovalent anions, such as a halide anion. Each of the A, B, and X sites may be occupied by multiple kinds of ions.

The thickness of the photoelectric conversion layer 3 is, for example, greater than or equal to 50 nm and less than or equal to 10 µm. The photoelectric conversion layer 3 can be formed using, for example, coating with a solution, printing, or deposition. The photoelectric conversion layer 3 may be formed by slicing a perovskite compound.

The photoelectric conversion layer 3 may be primarily a perovskite compound represented by the compositional formula ABX₃. In this context, "the photoelectric conversion layer 3 being primarily a perovskite compound represented by the compositional formula ABX₃" means the percentage of the perovskite compound represented by the compositional formula ABXs, in the photoelectric conversion layer 3 is higher than or equal to 90% by mass. The percentage of the perovskite compound represented by the compositional formula ABXs, in the photoelectric conversion layer 3 may be higher than or equal to 95% by mass. The photoelectric conversion layer 3 may be a layer of a perovskite compound represented by the compositional formula ABXs. The photoelectric conversion layer 3 only needs to contain a perovskite compound represented by the compositional formula ABX₃; it may contain defects or impurities.

The photoelectric conversion layer 3 may further contain extra compounds different from the perovskite compound represented by the compositional formula ABX₃. Examples of extra compounds include compounds having a Ruddlesden-Popper layered perovskite structure.

### (Porous Layer 6)

The porous layer 6 is formed on the electron transport layer 5, for example by coating. If the solar cell includes no electron transport layer 5, the porous layer 6 is formed on the first electrode 2. The pore structure introduced by the porous layer 6 serves as a foundation for the photoelectric conversion layer 3 to be formed. The porous layer 6 does not interfere with light absorption by the photoelectric conversion layer 3 or electron transfer from the photoelectric conversion layer 3 to the electron transport layer 5.

For the solar cells 200 and 400, the electron transport layer 5 has points at which it touches the photoelectric conversion layer 3 with the intermediate layer 8 therebetween. The porous material in the porous layer 6 has points at which it touches the photoelectric conversion layer 3 with the intermediate layer 8 therebetween. If the surface modification of the electron transport layer 5 or the porous material in the porous layer 6 with the intermediate layer 8 is insufficient, there can be points at which the electron transport layer 5 or the porous layer 6 touches the photoelectric conversion layer 3.

The porous layer 6 includes a porous material. An example of a porous material is a porous material formed by insulating or semiconductor particles linked together. Insulating particles can be, for example, particles of aluminum oxide or silicon oxide. Semiconductor particles can be inorganic semiconductor particles. An inorganic semiconductor can be an oxide of a metal element, a perovskite oxide of a metal element, a sulfide of a metal element, or a metal chalcogenide. Examples of oxides of metal elements include oxides of Cd, Zn, In, Pb, Mo, W, Sb, Bi, Cu, Hg, Ti, Ag, Mn, Fe, V, Sn, Zr, Sr, Ga, Si, and Cr. A more specific example is TiO₂. Examples of perovskite oxides of metal elements include SrTiO₃ and CaTiO₃. Examples of sulfides of metal elements include CdS, ZnS, In₂S₃, PbS, Mo₂S, WS₂, Sb₂S₃, Bi₂S₃, ZnCdS₂, and Cu₂S. Examples of metal chalcogenides include CsSe, In₂Se₃, WSe₂, HgS, PbSe, and CdTe.

The thickness of the porous layer 6 may be greater than or equal to 0.01 µm and less than or equal to 10 µm or may be greater than or equal to 0.05 µm and less than or equal to 1 µm.

As for the surface roughness of the porous layer 6, the surface roughness coefficient, given by the effective area/the projected area, may be greater than or equal to 10 or may be greater than or equal to 100. The projected area is the area of the shadow that appears behind an object irradiated with light from directly in front of it. The effective area is the actual surface area of the object. The effective area can be calculated from a volume determined from the projected area and thickness of the object and the specific surface area and bulk density of the material forming the object. The specific surface area is measured by, for example, nitrogen adsorption.

The pores in the porous layer 6 are continuous from the points at which the layer touches the photoelectric conversion layer 3, or, alternatively, the points at which the layer touches the photoelectric conversion layer 3 with the intermediate layer 8 therebetween, to the points at which the layer touches the electron transport layer 5, or, alternatively, the points at which the layer touches the electron transport layer 5 with the intermediate layer 8 therebetween. That is, the pores in the porous layer 6 are continuous from one primary surface of the porous layer 6 to the other primary surface of the porous layer 6. This allows the material for the intermediate layer 8 or photoelectric conversion layer 3 to fill the pores in the porous layer 6 and reach the surface of the electron transport layer 5. The photoelectric conversion layer 3 and the electron transport layer 5, therefore, are in contact with each other directly or with the intermediate layer 8 therebetween and thus are able to exchange electrons.

Providing the porous layer 6 is advantageous in that the formation of the photoelectric conversion layer 3 becomes easier. By virtue of the porous layer 6 being provided, the material for the photoelectric conversion layer 3 penetrates into the pores in the porous layer 6, and the porous layer 6 becomes a scaffold for the photoelectric conversion layer 3. It is, therefore, unlikely that the material for the photoelectric conversion layer 3 is repelled by or aggregates on the surface of the porous layer 6. As a result, the photoelectric conversion layer 3 can be formed as a uniform film easily. The same is true even if the intermediate layer 8 is on the porous layer 6. The photoelectric conversion layer 3 can be formed by, for example, the aforementioned coating, printing, or deposition.

Another advantage is also expected: Light scattering caused by the porous layer 6 can increase the optical path length of the light that passes through the photoelectric conversion layer 3. An increase in the optical path length will probably increase the quantity of electrons and holes generated in the photoelectric conversion layer 3.

### (Hole Transport Layer 7)

The hole transport layer 7 contains a hole transport material. A hole transport material is a material that transports holes. The hole transport layer 7 is made of a hole transport material such as an organic substance or inorganic semiconductor.

Examples of typical organic substances that are used as hole transport materials are 2,2',7,7'-tetrakis-(N,N-di-p-methoxyphenylamine)9,9'-spirobifluorene, poly[bis(4-phenyl)(2,4,6-trimethylphenyl)amine] (hereinafter it may be abbreviated to "PTAA"), poly(3-hexylthiophene-2,5-diyl), poly(3,4-ethylenedioxythiophene), and copper phthalocyanine.

Inorganic semiconductors that are used as hole transport materials are p-type semiconductors. Examples of inorganic semiconductors are Cu₂O, CuGaO₂, CuSCN, CuI, NiOₓ, MoOₓ, V₂O₅, and carbon materials like graphene oxide.

The hole transport layer 7 may include multiple layers that are made of different materials. For example, multiple layers stacked so that the hole transport layer 7 will have a gradient of ionization potentials descending from the ionization potential of the photoelectric conversion layer 3 provide improved hole-transporting characteristics.

By selecting an appropriate hole transport layer 7 according to the material forming the photoelectric conversion layer 3, hole-transporting characteristics are improved because defects in the photoelectric conversion layer 3 are passivated by atoms or molecules in the hole transport layer 7. An example of such a material, which passivates defects in the photoelectric conversion layer 3 and allows holes to pass through it, is tetracene.

The thickness of the hole transport layer 7 may be greater than or equal to 1 nm and less than or equal to 1000 nm or may be greater than or equal to 10 nm and less than or equal to 50 nm. When its thickness is in these ranges, the layer produces its full hole-transporting characteristics and maintains low resistance. The photovoltaic power generation process, therefore, is highly efficient.

The method for forming the hole transport layer 7 can be, for example, coating, printing, or deposition. This is the same as with the photoelectric conversion layer 3. Examples of coating techniques include doctor blading, bar coating, spraying, dip coating, and spin coating. An example of a printing technique is screen printing. Optionally, a hole transport layer 7 produced by mixing multiple materials together may be pressed, heat-treated, or otherwise treated. If the material for the hole transport layer 7 is an organic low-molecular-weight material or inorganic semiconductor, it is also possible to produce the hole transport layer 7 by vacuum deposition.

The hole transport layer 7 may contain a supporting electrolyte and a solvent. The support electrolyte and solvent have the effect of stabilizing holes in the hole transport layer 7.

Examples of supporting electrolytes include ammonium salts and alkali metal salts. Examples of ammonium salts include tetrabutylammonium perchlorate, tetraethylammonium hexafluorophosphate, imidazolium salts, and pyridinium salts. Examples of alkali metal salts include lithium perchlorate and potassium tetrafluoroborate .

A solvent contained in the hole transport layer 7 may be one that is superior in ionic conductivity. Both aqueous and organic solvents may be used. A solvent contained in the hole transport layer 7 may be an organic solvent so that the solute will be more stable. Specific examples include heterocyclic compound solvents, such as tert-butylpyridine, pyridine, and n-methylpyrrolidone.

For use as a solvent, an ionic liquid may be used alone or may be mixed with other solvent(s). Ionic liquids are desirable in that they have little volatility and high flame retardancy.

Examples of ionic liquids include ionic liquids such as imidazolium-based ones, such as 1-ethyl-3-methylimidazolium tetracyanoborate, pyridine-based ones, alicyclic amine-based ones, aliphatic amine-based ones, and azonium amine-derived ones.

### (Second Electrode 4)

The second electrode 4 is electrically conductive. If the solar cell includes no hole transport layer 7, the second electrode 4 is made of a material that does not make an ohmic contact with the photoelectric conversion layer 3. The second electrode 4, furthermore, has the ability to block electrons coming from the photoelectric conversion layer 3. In this context, the ability to block electrons coming from the photoelectric conversion layer 3 refers to a nature of being permeable only to holes generated in the photoelectric conversion layer 3; a nature of being impermeable to electrons. A material having such an ability is a material whose Fermi energy is lower than the lowest energy in the conduction band of the photoelectric conversion layer 3. This material may be a material whose Fermi energy is lower than the Fermi energy of the photoelectric conversion layer 3. Specific examples of materials include platinum, gold, and carbon materials, such as graphene. If the solar cell includes a hole transport layer 7, the second electrode 4 does not need have the ability to block electrons coming from the photoelectric conversion layer 3. That is, the second electrode 4 may be made of a material that makes an ohmic contact with the photoelectric conversion layer 3. The second electrode 4, therefore, can be formed to be translucent.

Of the first electrode 2 and the second electrode 4, only the one electrode on which the light is incident needs to be translucent. One of the first electrode 2 and second electrode 4, therefore, does not need to be translucent. That is, one of the first electrode 2 and second electrode 4 does not need to be made with a translucent material and does not need to have a pattern that includes open portion(s) for the light to pass through.

### EXAMPLES

The present disclosure will now be described in further detail with reference to examples and comparative examples.

In the examples and comparative examples, solar cells made with a perovskite compound were produced, and the initial characteristics and the characteristics after a light irradiation test of the solar cells were evaluated.

Each component of the solar cells of Examples 1 to 11 and Comparative Examples 1 to 10 is as follows. The solar cells of Examples 1 to 10, Comparative Examples 1 to 5, and Comparative Examples 7 and 8 had the same structure as the solar cell 400, illustrated in Fig. 6. The solar cell of Comparative Example 9 had a structure of the solar cell 400 excluding the intermediate layer 8. The solar cells of Example 11 and Comparative Example 6 had the same structure as the solar cell 300, illustrated in Fig. 5. The solar cell of Comparative Example 10 had a structure of the solar cell 300 excluding the intermediate layer 8.
- The substrate 1: A glass substrate
- The first electrode 2: A transparent electrode; an indium-tin composite oxide layer
- The electron transport layer 5: Titanium oxide or tin oxide
- The porous layer 6: Mesoporous-structured titanium oxide
- The intermediate layer 8 (C60SAM): 4-(1',5'-Dihydro-1'-methyl-2'H-[5,6]fullereno-C₆₀-Ih-[1,9-c]pyrrol-2'-yl)benzoic acid (manufactured by Sigma-Aldrich Co. LLC) (hereinafter referred to as "SAM[1]") or (1,2-Methanofullerene C₆₀)-61-carboxylic acid (manufactured by Sigma-Aldrich Co. LLC) (hereinafter referred to as "SAM[7]")
- The intermediate layer 8 (space-modifying SAM): Isonicotinic acid (manufactured by Tokyo Chemical Industry Co., Ltd.), nicotinic acid (manufactured by Tokyo Chemical Industry Co., Ltd.), picolinic acid (manufactured by Tokyo Chemical Industry Co., Ltd.), 2-bromoisonicotinic acid (manufactured by Tokyo Chemical Industry Co., Ltd.), or isonipecotic acid (manufactured by Sigma-Aldrich Co. LLC)
- The photoelectric conversion layer 3: A layer that is primarily HC(NHz)zPbIs
- The hole transport layer 7: A layer containing n-butylammonium bromide (manufactured by Greatcell Solar Ltd.)/a layer that is primarily PTAA (although tris(pentafluorophenyl)borane (manufactured by Tokyo Chemical Industry Co., Ltd.) was contained as an additive)
- The second electrode 4: Au

### <Production of Solar Cells>

### (Example 1)

First, a substrate 1 having a transparent electrically conductive layer, which would function as the first electrode 2, on its surface was prepared. In this example, the substrate 1 was a glass substrate having a thickness of 0.7 mm.

A layer of indium-tin composite oxide was formed on the substrate 31 by sputtering as the first electrode 2.

Then a layer of titanium oxide was formed on the first electrode 2 by sputtering as the electron transport layer 5.

The porous layer 6 was a titanium oxide in a mesoporous structure. The mesoporous-structured titanium oxide porous layer 6 was formed by applying 30NR-D (manufactured by Greatcell Solar Ltd.) to the electron transport layer 5 by spin coating and then heat-treating the applied coating at 500°C for 30 minutes.

Then the intermediate layer 8 was formed using the dipping method described in the Embodiments section. The parameters for the formation of the intermediate layer 8 in Example 1 are presented in Table 1. The tetrahydrofuran and ethanol were those available from FUJIFILM Wako Pure Chemical.

Then a raw-material solution for the photoelectric conversion material was applied by spin coating to form a photoelectric conversion layer 3 containing a perovskite compound. This raw-material solution was a solution containing 0.92 mol/L of lead(II) iodide (manufactured by Tokyo Chemical Industry Co., Ltd.), 0.17 mol/L of lead(II) bromide (manufactured by Tokyo Chemical Industry Co., Ltd.), 0.83 mol/L of formamidinium iodide (manufactured by GreatCell Solar Ltd.), 0.17 mol/L of methylammonium bromide (manufactured by GreatCell Solar Ltd.), 0.05 mol/L of cesium iodide (manufactured by Iwatani Corporation), and 0.05 mol/L of rubidium iodide (manufactured by Iwatani Corporation). The solvent for this solution was a mixture of dimethyl sulfoxide (manufactured by Acros Organics) and N,N-dimethylformamide (manufactured by Acros Organics). The mix ratio between the dimethyl sulfoxide (DMSO) and the N,N-dimethylformamide (DMF) in the first raw-material solution (DMSO:DMF) was 1:4 as a ratio by volume.

Then a hole transport layer 7 containing PTAA was formed by applying a raw-material solution for the hole transport material to the photoelectric conversion layer 3 by spin coating. The solvent for the raw-material solution was toluene (manufactured by Acros Organics), and the solution contained 10 g/L of PTAA.

Then the second electrode 4 was formed by depositing a Au film on the hole transport layer 7 by vacuum deposition. In such a way, a solar cell of Example 1 was obtained.

### (Examples 2 to 10)

Solar cells of Examples 2 to 10 were obtained in the same way as in Example 1, except for the parameters for the formation of the intermediate layer 8. The parameters for the formation of the intermediate layer 8 in Examples 2 to 10 are presented in Table 1.

### (Example 11)

In Example 11, the electron transport layer 5 was formed with tin oxide. In Example 11, furthermore, no porous layer 6 was formed. Except for these, a solar cell of Example 11 was obtained in the same way as in Example 1.

### (Comparative Examples 1 to 5)

Solar cells of Comparative Examples 1 to 5 were obtained in the same way as in Example 1, except for the parameters for the formation of the intermediate layer 8. The parameters for the formation of the intermediate layer 8 in Comparative Examples 1 to 5 are presented in Table 1.

### (Comparative Example 6)

A solar cell of Comparative Example 6 was obtained in the same way as in Example 11, except for the parameters for the formation of the intermediate layer 8. The parameters for the formation of the intermediate layer 8 in Comparative Example 6 are presented in Table 2.

### (Comparative Examples 7 and 8)

Solar cells of Comparative Examples 7 and 8 were obtained in the same way as in Example 1, except for the parameters for the formation of the intermediate layer 8. The parameters for the formation of the intermediate layer 8 in Comparative Examples 7 and 8 are presented in Table 3.

### (Comparative Example 9)

In Comparative Example 9, no intermediate layer 8 was formed. A solar cell of Comparative Example 9 was obtained in otherwise the same way as in Example 1.

### (Comparative Example 10)

In Comparative Example 10, no intermediate layer 8 was formed. A solar cell of Comparative Example 10 was obtained in otherwise the same way as in Example 11.

### <Measurement of Photoelectric Conversion Efficiency>

The photoelectric conversion efficiency of the resulting solar cells of Examples 1 to 11 and Comparative Examples 1 to 10 was measured.

The measurement of the photoelectric conversion efficiency of the solar cells was done using an electrochemical analyzer (ALS440B, manufactured by BAS Inc.) and a xenon light source (BPS X300BA, manufactured by Bunkoukeiki Co., Ltd). Before the measurement, the intensity of light was calibrated to 1 Sun (100 mW/cm²) using a silicon photodiode. The voltage sweep rate was 100 mV/s. No preconditioning, such as light illumination or prolonged application of a forward bias, was performed before the start of the measurement. The solar cells were masked with a black mask with an aperture of 0.1 cm² and irradiated in that state with light on their mask/substrate side so that the effective area would be fixed and that the influence of scattered light would be reduced. The measurement of the photoelectric conversion efficiency was done in a dry air (<2% RH) at room temperature. The initial efficiencies of the solar cells of Examples 1 to 11 and Comparative Examples 1 to 10 measured in such a way are presented in Tables 1, 2, and 3.

### <Light Irradiation Test>

A light irradiation test was performed on the solar cells of Examples 1 to 11 and Comparative Examples 1 to 10. In the light irradiation test, the solar cells were sealed in the air with a UV-curable resin using pieces of sealing glass having attached moisture and oxygen getters inside. Then the solar cells were maintained near their optimum operating point, and at the same time their substrate side was irradiated with light equivalent to 1 Sun for 1 hour with the substrate temperature maintained at 50°C.

For Examples 1 to 10 and Comparative Examples 1 to 5 (the material for the electron transport layer 5 was titanium oxide, and the porous layer 6 was mesoporous-structured titanium oxide), the C60SAM used, the space-modifying SAM used, and their initial molarity in the first and second processes of forming the intermediate layer 8 and the initial efficiency (%), which is the photoelectric conversion efficiency before the light irradiation test, and the normalized efficiency after the light irradiation test are presented in Table 1. In Table 1, the concentration of a saturated solution of the C60SAM is denoted as a. The unit of the concentrations in Table 1, furthermore, is mol/L. The parenthesized value in the Initial efficiency column is the initial efficiency in that example normalized by the conversion efficiency in Comparative Example 1. The normalized efficiency after light illumination is the photoelectric conversion efficiency of the cell after the light irradiation test normalized by 16.7%, the average photoelectric conversion efficiency over the period of 0 to 1 hour after light illumination in Comparative Example 1.

**[Table 1]**

| | First process for forming the intermediate layer | Second process for forming the intermediate layer | Initial efficiency (%) | Normalized efficiency after light illumination |
|---|---|---|---|---|
| Example 1 | SAM[1] (concentration, a) | Isonicotinic acid (concentration, 8.1×10⁻³) | 18.7 (1.08) | 1.06 |
| Example 2 | SAM[1] (concentration, a) | Nicotinic acid (concentration, 8.1×10⁻³) | 17.6 (1.02) | 1.05 |
| Example 3 | SAM[1] (concentration, a) | Picolinic acid (concentration, 8.1×10⁻³) | 17.5 (1.01) | 1.01 |
| Example 4 | SAM[1] (concentration, a) | 2-Bromoisonicotinic acid (concentration, 5.0×10⁻³) | 16.6 (0.96) | 1.02 |
| Example 5 | SAM[1] (concentration, 0.5a)+Isonicotinic acid (concentration, 4.1×10⁻⁴) | - | 18.6 (1.08) | 1.10 |
| Example 6 | SAM[1] (concentration, 0.5a)+Isonicotinic acid (concentration, 4.1×10⁻⁵) | - | 18.1 (1.05) | 1.03 |
| Example 7 | SAM[1] (concentration, 0.05a)+Isonicotinic acid (concentration, 4.1×10⁻⁶) | - | 17.6 (1.02) | 1.03 |
| Example 8 | SAM[1] (concentration, 0.5a)+Nicotinic acid (concentration, 4.1×10⁻⁴) | - | 18.8 (1.09) | 1.08 |
| Example 9 | SAM[1] (concentration, 0.5a)+Nicotinic acid (concentration, 4.1×10⁻⁵) | - | 18.2 (1.05) | 1.03 |
| Example 10 | SAM[1] (concentration, 0.5a)+Nicotinic acid (concentration, 4.1×10⁻⁶) | - | 18.4 (1.07) | 1.05 |
| Comparative Example 1 | SAM[1] (concentration, a) | - | 17.3 (1.00) | 1.00 |
| Comparative Example 2 | SAM[1] (concentration, a) | Isonipecotic acid (saturation concentration) | 15.8 (0.92) | 0.97 |
| Comparative Example 3 | Isonicotinic acid (concentration, 8.1×10⁻³) | | 10.1 (0.58) | 0.783 |
| Comparative Example 4 | Nicotinic acid (concentration, 8.1×10⁻³) | | 13.0 (0.75) | 0.85 |
| Comparative Example 5 | Picolinic acid (concentration, 8.1×10⁻³) | - | 14.5 (0.84) | 0.85 |

For Example 11 and Comparative Example 6 (the material for the electron transport layer 5 was tin oxide, and there was no porous layer 6), the C60SAM used, the space-modifying SAM used, and their initial molarity in the first and second processes of forming the intermediate layer 8 and the initial efficiency (%), which is the photoelectric conversion efficiency before the light irradiation test, and the normalized efficiency after the light irradiation test are presented in Table 2. In Table 2, the concentration of a saturated solution of the C60SAM is denoted as a. The unit of the concentrations in Table 2, furthermore, is mol/L. The parenthesized value in the Initial efficiency column is the initial efficiency in that example normalized by the conversion efficiency in Comparative Example 6. The normalized efficiency after light illumination is the photoelectric conversion efficiency of the cell after the light irradiation test normalized by 13.3%, the average photoelectric conversion efficiency over the period of 0 to 1 hour after light illumination in Comparative Example 6.

**[Table 2]**

| | First process for forming the intermediate layer | Second process for forming the intermediate layer | Initial efficiency (%) | Normalized efficiency after light illumination |
|---|---|---|---|---|
| Example 11 | SAM[1] (concentration, a) | Isonicotinic acid (concentration, 8.1×10⁻³) | 14.1 (1.03) | 1.04 |
| Comparative Example 6 | SAM[1] (concentration, a) | - | 13.7 (1.00) | 1.00 |

For Comparative Examples 7 to 9 (the material for the electron transport layer 5 was titanium oxide, and the porous layer 6 was mesoporous-structured titanium oxide) and Comparative Example 10 (the material for the electron transport layer 5 was tin oxide, and there was no porous layer 6), the C60SAM used, the space-modifying SAM used, and their initial molarity in the first and second processes of forming the intermediate layer 8 and the initial efficiency (%), which is the photoelectric conversion efficiency before the light irradiation test, and the normalized efficiency after the light irradiation test are presented in Table 3. In Table 3, the concentration of a saturated solution of the C60SAM is denoted as a. The unit of the concentrations in Table 3, furthermore, is mol/L. The parenthesized value in the Initial efficiency column in Comparative Examples 7 to 9 is the initial efficiency in that example normalized by the conversion efficiency in Comparative Example 1, presented in Table 1. The parenthesized value in the Initial efficiency column in Comparative Example 10 is the same efficiency normalized by the conversion efficiency in Comparative Example 6, presented in Table 2. The normalized efficiency after light illumination in Comparative Examples 7 to 9 is the photoelectric conversion efficiency of the cell after the light irradiation test normalized by 16.7%, the average photoelectric conversion efficiency over the period of 0 to 1 hour after light illumination in Comparative Example 1. The normalized efficiency after light illumination in Comparative Example 10 is the same efficiency normalized by 13.3%, the average photoelectric conversion efficiency over the period of 0 to 1 hour after light illumination in Comparative Example 6.

**[Table 3]**

| | First process for forming the intermediate layer | Second process for forming the intermediate layer | Initial efficiency (%) | Normalized efficiency after light illumination |
|---|---|---|---|---|
| Comparative Example 7 | SAM[7] (concentration, a) | | 17.4 (1.01) | 0.96 |
| Comparative Example 8 | SAM[7] (concentration, a) | Isonicotinic acid (concentration, 8.1×10⁻³) | 16.8 (0.97) | 0.93 |
| Comparative Example 9 | - | - | 17.3 (1.00) | 0.93 |
| Comparative Example 10 | - | - | 13.2 (0.96) | 0.91 |

### <Verification of the Effects of the Space-Modifying SAM>

As shown in Table 1, Examples 1 to 10 are highly efficient in photoelectric conversion after light illumination compared with Comparative Example 1, in which a known C60SAM treatment was the only treatment, as demonstrated by a normalized efficiency after light illumination greater than 1.000. By applying treatment with a space-modifying SAM in addition to treatment with a C60SAM, therefore, a solar cell having a high photoelectric conversion efficiency is obtained with the phenomenon of light-induced degradation controlled.

### <Verification of the Requirements for the Space-Modifying SAM>

In Example 4, the influence of steric hindrance was investigated by using 2-bromoisonicotinic acid, which has a structure in which isonicotinic acid is modified with bromine, as the space-modifying SAM. 2-Bromoisonicotinic acid has the structure represented by formula (17) below.

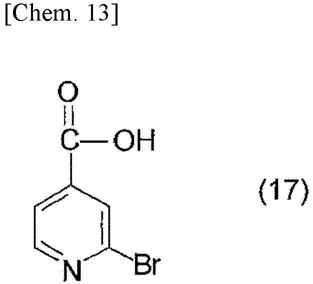

As shown in Table 1, in Example 4, the photoelectric conversion efficiency after light illumination is high compared with that in Comparative Example 1 as demonstrated by a normalized efficiency after light illumination of 1.02. This indicates that even with a space-modifying SAM modified with bromine, a solar cell highly efficient in photoelectric conversion after light illumination is obtained with reduced light-induced degradation. In Example 4, however, the initial efficiency decreased compared with those in Examples 1 to 3, Examples 5 to 10, and Comparative Example 1. This can presumably be explained as follows: The initial efficiency decreased because 2-bromoisonicotinic acid has some difficulty entering spaces between SAM[1] molecules, and, therefore, SAM[1] and 2-bromoisonicotinic acid fail to modify the surface of the electron transport layer 5 sufficiently.

When the space-modifying SAMs in the Examples are compared, 2-bromoisonicotinic acid, used in Example 4, contains the largest heterocycle. The size of the heterocycle means the longest distance between two of its atoms, i.e., the distance from the bromine to the hydrogen in the para position in relation to the bromine. The size of this heterocycle, therefore, is 795 pm, the total of the length of a carbon-bromine bond (194 pm), the diameter of a benzene ring (278 pm), the length of a carbon-hydrogen bond (150 pm), the radius of a hydrogen atom (53 pm), and the radius of a bromine atom (120 pm).

In Comparative Example 2, the influence of electron repulsion by the lone electron pair(s) present in the ring of the space-modifying SAM heterocyclic compound was investigated by using isonipecotic acid (also known as 4-piperidinecarboxylic acid) as the space-modifying SAM. In this context, isonipecotic acid has the structure represented by formula (18) below. No element in the piperidine ring of isonipecotic acid has a lone electron pair. Isonipecotic acid has an appropriate size that allows it to enter spaces between SAM[1] molecules.

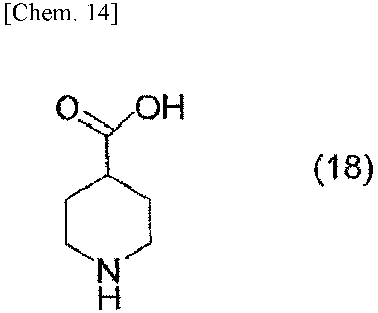

As shown in Table 1, in Comparative Example 2, compared with Comparative Example 1, both of the initial efficiency and the normalized efficiency after light illumination decreased. This means that even if the size of the space-modifying SAM is appropriate, the desired advantages are not achieved if the ring of the space-modifying SAM heterocyclic compound has no lone electron pair. Presumably, the initial efficiency decreased because isonipecotic acid does not produce electron repulsion, and, therefore, the electrons that should have been collected into the C₆₀ of the C60SAM were collected through the space-modifying SAM, which produces great resistive losses. As for the decrease in efficiency after light illumination, photodurability decreased presumably because the cathodic reaction at the interface between the electron transport layer 5 and the photoelectric conversion layer 3 was accelerated as a result of the electron collection done through isonicotinic acid, which is a space-modifying SAM that produces great resistive losses, or, in other words, through a layer from which the extraction of high-energy, photoexcited electrons was inefficient.

Based on these results, as shown in Examples 1 to 10, a solar cell that suffers the phenomenon of light-induced degradation only to a limited extent and is highly efficient in photoelectric conversion after light illumination can be obtained if the space-modifying SAM is formed by a group of materials that are heterocyclic compounds having a lone electron pair in their ring. As shown in Examples 1 to 3 and Examples 5 to 10, furthermore, the results indicate that a high photoelectric conversion efficiency can be achieved with the phenomenon of light-induced degradation controlled if the space-modifying SAM is formed by a group of materials that are heterocyclic compounds having a lone electron pair in their ring and if the space-modifying SAM is of a size that causes little steric hindrance.

### <Verification of What Occurs If the Intermediate Layer Contains a Space-Modifying SAM Alone>

As shown in Table 1, in Comparative Examples 3 to 5, in which the intermediate layer 8 was formed through treatment with a space-modifying SAM alone, both of the initial efficiency and the normalized efficiency after light illumination significantly decreased compared with those in Comparative Example 1. This is because the electron collection into the electron transport layer 5 is interfered with by the repulsion of electrons by the lone electron pair the nitrogen in the pyridine ring has. The decrease in initial efficiency, therefore, presumably resulted from an increase in resistive loss, and the decrease in normalized efficiency after light illumination, i.e., the decrease in photodurability, is presumably because the cathodic reaction at the interface between the electron transport layer 5 and the photoelectric conversion layer 3 was accelerated as a result of the accumulation of high-energy, photoexcited electrons at the interface during the light illumination.

### <Verification of the Influence of the Material for the Electron Transport Layer 5>

As shown in Table 2, it was examined whether the effects of the space-modifying SAM depend on the material for the electron transport layer 5 by comparing Example 11 and Comparative Example 6. In Example 11 and Comparative Example 6, the electron transport layer 5 was tin oxide. Compared with Comparative Example 6, in which the intermediate layer 8 was SAM[1] alone, Example 11, in which the intermediate layer 8 contained SAM[1] and isonicotinic acid, exhibited both a high initial efficiency and a high normalized efficiency after light illumination. It was, therefore, verified that a space-modifying SAM produces similar effects even if the material for the electron transport layer 5 is tin oxide.

### <Verification of the Influence of the Size of the C60SAM>

It was examined whether a space-modifying SAM produces its effects if SAM[7], small in the size of the framework excluding C₆₀ compared with SAM[1], is used as the C60SAM. Comparative Example 7 is a case in which the intermediate layer 8 contained SAM[7] alone. Comparative Example 8, on the other hand, is a case in which the intermediate layer 8 was formed by forming SAM[7] first and then attempting space modification with isonicotinic acid. As shown in Table 3, Comparative Example 7 exhibited an initial efficiency comparable to that in Comparative Example 1, in Table 1, but was worse than Comparative Example 1 in terms of efficiency after light illumination. This suggests that with SAM[7], compared with SAM[1], the modification of the surface of the electron transport layer 5 was insufficient because steric hindrance caused by repulsion between C_{60S} was great. In Comparative Example 8, compared with Comparative Example 7, the initial efficiency decreased, and the efficiency after light illumination decreased. This is presumably because isonicotinic acid cannot enter spaces between SAM[7] molecules, and therefore fails to modify the surface of the electron transport layer 5 sufficiently, due to too small a size of the framework of SAM[7] excluding C₆₀. The decrease in efficiency after light illumination, furthermore, is a result of increased electron collection through a layer that produces great resistive losses. More specifically, the decrease in efficiency after light illumination is because the cathodic reaction at the interface between the electron transport layer 5 and the photoelectric conversion layer 3 was accelerated, and the cell experienced light-induced degradation, as a result of mediation by a layer from which the extraction of high-energy, photoexcited electrons was inefficient. If the size of the framework of the C60SAM excluding C₆₀ is smaller than that of the space-modifying SAM, therefore, the desired advantages are not achieved because in that case no sufficient space is available for the space-modifying SAM to enter.

### <Verification of the Effects of the C60SAM>

Comparative Examples 9 and 10 were without an intermediate layer 8. The electron transport layer 5 in Comparative Example 9 was mesoporous-structured titanium oxide; this comparative example corresponds to a case in which there was no SAM[1] in the intermediate layer 8 in Comparative Example 1. The electron transport layer 5 in Comparative Example 10 is tin oxide; this comparative example corresponds to a case in which there was no SAM[1] in the intermediate layer 8 in Comparative Example 6. As shown in Tables 1 to 3, in Comparative Examples 9 and 10, compared with Comparative Examples 1 and 6, in which there was SAM[1] in the intermediate layer 8, the initial efficiency was almost comparable, but the normalized efficiency after light illumination decreased greatly. This indicates that the absence of the intermediate layer 8 accelerates light-induced degradation because in that case electron extraction is poor due to many defects in the interface between the electron transport layer 5 and the photoelectric conversion layer 3.

Overall, it was verified that the inclusion of an appropriate C60SAM and space-modifying SAM as an intermediate layer 8 is very effective in improving photoelectric conversion efficiency.

### Industrial Applicability

The present disclosure is a solar cell having a novel self-assembled monolayer. This self-assembled monolayer helps improve photoelectric conversion efficiency when used in an intermediate layer of a solar cell, and, therefore, has an extremely high industrial applicability.

### Reference Signs List

1A, 2A SAM[1]
1B, 2B, 5 electron transport layer
2C isonicotinic acid
1 substrate
2 first electrode
3 photoelectric conversion layer
4 second electrode
6 porous layer
7 hole transport layer
8 intermediate layer
100, 200, 300, 400 solar cell

## Claims

1. A solar cell comprising:
a first electrode, an intermediate layer, a photoelectric conversion layer, and a second electrode in this order, wherein:
the intermediate layer contains at least one compound A selected from compound group I, which consists of formulae (1) to (4) below, and at least one compound B selected from compound group II, which consists of formulae (5) and (6) below: 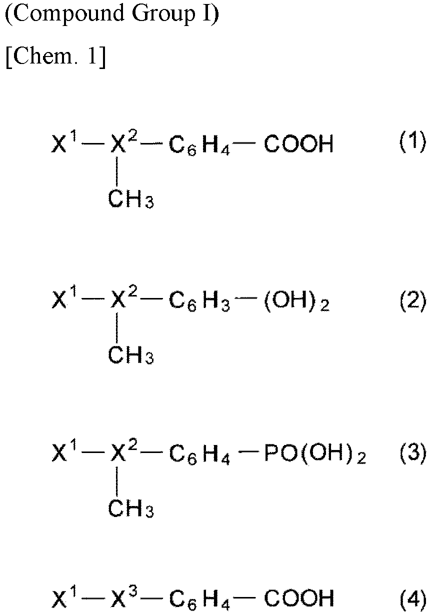 wherein, in formulae (1) to (4) above,
X¹ is fullerene or a fullerene derivative,
X² is a pyrroline ring, pyrrole ring, pyrrolidine ring, cyclohexane ring, or cyclohexene ring, and
X³ is a cyclohexadiene ring; 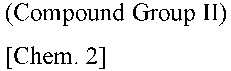 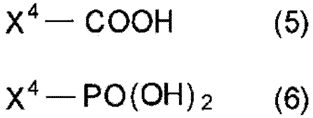
wherein, in formulae (5) and (6) above,
X⁴ is a heterocycle containing a heteroatom with one or more lone electron pairs and having a size smaller than or equal to 900 pm at the same time.

2. The solar cell according to claim 1, wherein:
the heterocycle is a pyridine ring, pyran ring, furan ring, oxetane ring, oxazole ring, isoxazole ring, pyridazine ring, pyrimidine ring, pyrazine ring, triazine ring, tetrazine ring, triazole ring, thiophene ring, thiazole ring, dioxane ring, pyrazole ring, imidazole ring, phosphinine ring, oxirane ring, thiirane ring, thietane ring, imidazoline ring, dioxolane ring, tetrahydrofuran ring, tetrahydrothiophene ring, morpholine ring, dithiane ring, quinuclidine ring, or azaadamantane ring.

3. The solar cell according to claim 1 or 2, wherein:
at least a subset of hydrogen atoms in the heterocycle is replaced with a halogen atom.

4. The solar cell according to any one of claims 1 to 3, further comprising an electron transport layer, wherein:
the electron transport layer is between the first electrode and the intermediate layer.

5. The solar cell according to any one of claims 1 to 4, wherein:
the compound A is at least one selected from compounds represented by formulae (7) to (11) below, and the compound B is at least one selected from the group consisting of isonicotinic acid, nicotinic acid, and picolinic acid.

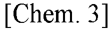

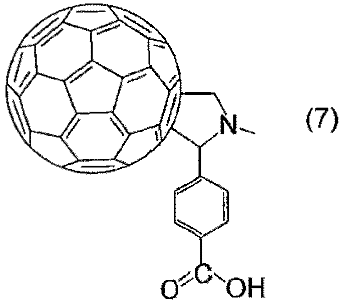

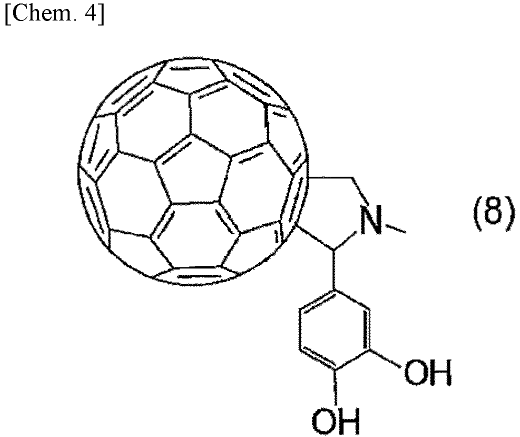

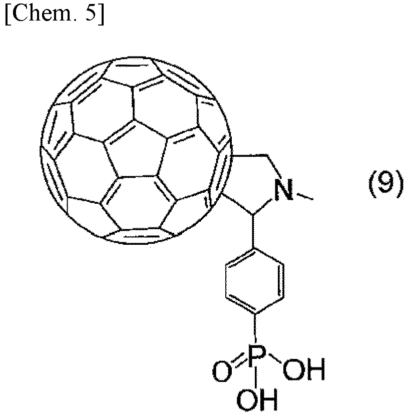

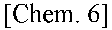

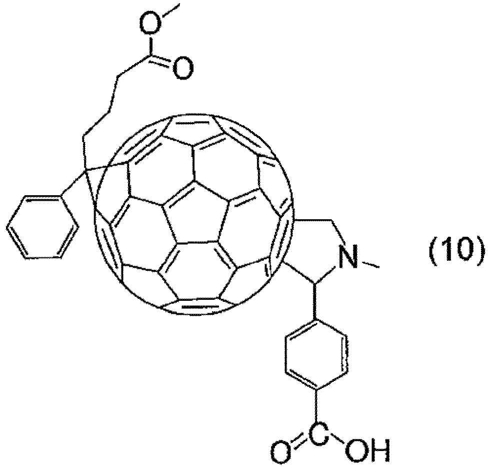

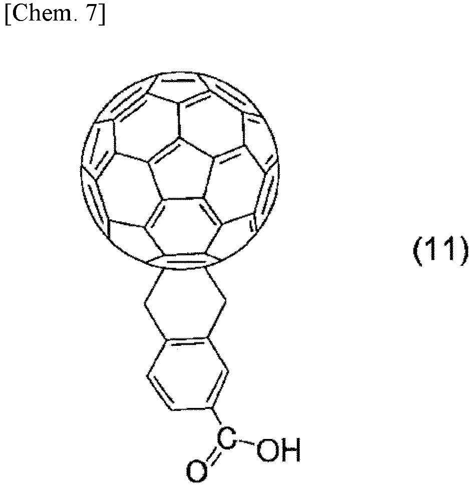

6. The solar cell according to claim 5, wherein:
the compound A is the compound represented by formula (7) above.

7. The solar cell according to any one of claims 1 to 6, wherein:
the photoelectric conversion layer contains a perovskite compound.

8. The solar cell according to claim 4, wherein:
the electron transport layer contains titanium oxide or tin oxide.
